## Europäisches Patentamt
## European Patent Office
## Office européen des brevets

(19)

(11) Veröffentlichungsnummer : **0 114 193**
**B1**

(12)

# EUROPÄISCHE PATENTSCHRIFT

(45) Veröffentlichungstag der Patentschrift :
**18.06.86**

(51) Int. Cl.⁴ : **C 04 B 35/58, H 01 B 3/12,
H 01 L 23/14**

(21) Anmeldenummer : **83109731.6**

(22) Anmeldetag : **29.09.83**

(54) **Keramischer Träger.**

(30) Priorität : **24.12.82 DE 3247985**

(43) Veröffentlichungstag der Anmeldung :
**01.08.84 Patentblatt 84/31**

(45) Bekanntmachung des Hinweises auf die Patenterteilung : **18.06.86 Patentblatt 86/25**

(84) Benannte Vertragsstaaten :
**AT BE CH DE FR GB IT LI LU NL**

(56) Entgegenhaltungen :
EP-A- 0 075 857
DE-A- 2 035 767
US-A- 3 833 389
CHEMICAL ABSTRACTS, Band 91, Nr. 24, 24. Dezember 1979, Seite 298, Nr. 197775q, Columbus, Ohio,
USA
CHEMICAL ABSTRACTS, Band 97, Nr. 10, September
1982, Seite 326, Nr. 77483v, Columbus, Ohio, USA
CHEMICAL ABSTRACTS, Band 95, Nr. 1, Juli 1981,
Seite 267, Nr. 11386t, Columbus, Ohio, USA K.I.
RYATSEV et al.: "Effect of some additives on the
fritting and microstructure on aluminum nitride ceramics"
CHEMICAL ABSTRACTS, Band 77, Nr. 26, 25. Dezember 1972, Seiten 225-226, Nr. 168047j, Columbus,
Ohio, USA

(73) Patentinhaber : **W.C. Heraeus GmbH**
**Heraeusstrasse 12 - 14**
**D-6450 Hanau / Main (DE)**

(72) Erfinder : **Aldinger, Fritz, Dr. Dipl.-Ing.**
**Barbarossastrasse 44**
**D-6450 Rodenbach 2 (DE)**
Erfinder : **Keilberth, Richard**
**Löwensteinring 25**
**D-8764 Kleinheubach (DE)**
Erfinder : **Werdecker, Waltraud, Dipl.-Ing.**
**Gustav-Hoch-Strasse 11**
**D-6450 Hanau (DE)**

(74) Vertreter : **Heinen, Gerhard, Dr.**
**Heraeusstrasse 12-14**
**D-6450 Hanau/Main (DE)**

## Beschreibung

Die Erfindung betrifft einen keramischen Träger auf Aluminium-nitrid-Basis mit hoher thermischer Leitfähigkeit für Halbleiterbauelemente oder elektronische Schaltungen.

Bei Trägern für elektronische Schaltungen treten Probleme bei der Wärmeableitung auf, die mit wachsender Integrationsdichte immer größer werden. Für Hochleistungsanwendungen werden bereits Träger aus Berylliumoxid eingesetzt, die eine fast achtfache bessere Wärmeleitfähigkeit gegenüber den herkömmlichen Aluminiumoxidträgern aufweisen, aber wesentlich teurer sind als die herkömmlichen Träger aus reinem Aluminiumoxid. Als besonderes Problem wird die extreme Toxizität von Berylliumoxidstäuben empfunden, die eine Nachbearbeitung (z. B. Schleifen oder Polieren) des Anwenders ausschließt. Die Bearbeitung muß in überwachten Spezialwerkstätten erfolgen.

Aus Chemical Abstracts 91, 197775 und 97, 77483 sind aus siliciumhaltigem Aluminiumnitrid-Pulver unter Zusatz von 0,5 bis 3 % $Al_2O_3$, $MnO_2$, CaO, SrO und/oder BaO oder unter Zusatz von 0,5 bis 8 % MgO durch Sintern beziehungsweise Heißpressen hergestellte keramische Träger für Schaltungen bekannt.

Der vorliegenden Erfindung liegt die Aufgabe zugrunde, einen Träger zu schaffen, der eine bessere Leitfähigkeit als Aluminiumoxidträger aufweist, kostengünstiger herstellbar ist als ein Berylliumoxidträger und ungiftig ist.

Gelöst wird die Aufgabe für einen Träger der eingangs charakterisierten Art erfindungsgemäß dadurch, daß er aus Aluminiumnitrid mit einem Zusatz aus 0,1 bis 3 Gewichts-% Bornitrid oder 0,1 bis 5 Gewichts-% Titan-, Zirkonium- und/oder Chromoxid oder 2 Gewichts-% Yttriumoxid besteht.

Vorzugsweise beträgt der Zusatz an Bornitrid 0,5 bis 2 Gewichts-%.

Die Vorteile des erfindungsgemäß ausgebildeten Trägers liegen darin, daß er aus einem Material besteht, das gute dielektrische Eigenschaften und eine gute Temperaturwechselbeständigkeit bei gleichzeitiger besserer Wärmeleitfähigkeit gegenüber Aluminiumoxid aufweist und das kostengünstiger als Beryllium-oxid herstellbar ist. Ein weiterer Vorteil des erfindungsgemäßen Trägers ist die Ungiftigkeit.

An sich ist Aluminiumnitrid aufgrund seines kovalenten Bindungscharakters nicht sinterfähig, so daß durch druckloses Sintern keine hohe Dichte und keine hohe mechanische Festigkeit erreicht werden kann. Bei einer niedrigen Dichte, d. h. bei einem Material mit einer hohen Porosität, kann bekannterweise auch nicht der theoretische Wert für die Wärmeleitfähigkeit erreicht werden, der für AlN mit 320 W/m K weit über dem theoretischen Wärmeleitfähigkeitswert des Aluminiumoxids (28 W/m K) liegt.

Der erfindungsgemäße Träger mit Aluminiumnitrid als Grundmaterial wird durch Sintern in Stickstoffatmosphäre unter Verwendung von Bornitridzusätzen oder oxidischen Zusätzen hergestellt. Durch den Zusatz von Bornitrid oder oxidischen Zusätzen ist es nun gelungen, eine hohe Dichte und eine hohe Wärmeleitfähigkeit zu erreichen, die je nach Art und Menge des Zusatzes teilweise über der Wärmeleitfähigkeit von handelsüblichem Berylliumoxid liegt. Der theoretische Wärmeleitfähigkeitswert von Berylliumoxid (porenfreies, hochreines Material) liegt bei 218 W/m K. Aufgrund der hohen Verdichtung wird zusätzlich eine hohe mechanische Festigkeit erreicht. Die Oxidzusätze sind vom Standpunkt der guten Verdichtbarkeit des Aluminiumnitrids ebenso gut geeignet wie das Bornitrid. Mit Oxidzusätzen wurde die höchste Wärmeleitfähigkeit realisiert.

Beispiel 1

100 g einer Pulvermischung aus 99 Gewichts-% Aluminiumnitrid und einem Gewichts-% Bornitrid wurden 25 Stunden in einem Keramikgefäß mit 100 g Keramikmahlkörpern aufgemahlen. Diese Mischung wurde durch ein Sieb mit einer Maschenweite von 200 µm durchgesiebt. Das so aufbereitete Pulver wurde in einer Matrize zu Plättchen gepreßt.

Nach Einbringen der Plättchen in eine graphitbeheizte Sinteranlage wurde diese auf $10^{-5}$ mbar abgepumpt und anschließend ein Stickstoffdruck von 5 mbar eingeregelt. Innerhalb von 3 Stunden wurde auf eine Temperatur von 1 300 °C aufgeheizt. Während dieser Periode wurde ein Stickstoffdruck von 5 mbar aufrechterhalten. Bei 1 300 °C wurde ein Stickstoffdruck von 140 mbar aufgegeben, und die Ventile wurden geschlossen. Innerhalb von 1 Stunde wurde auf 1 900 °C aufgeheizt. Bei dieser Temperatur hat sich ein Stickstoffdruck von 190 mbar eingestellt. Nach einer zweistündigen Haltezeit bei diesen Bedingungen wurde die Anlage abgeschaltet und innerhalb von ca. 12 Stunden auf Raumtemperatur abgekühlt. Danach wurde die Anlage geflutet und der fertig gesinterte Träger entnommen. Der so hergestellte Träger kann unmittelbar eingesetzt oder gegebenenfalls beschnitten und einseitig poliert werden.

Beispiel 2

100 g einer Pulvermischung aus 98,0 Gewichts-% feinem Aluminiumnitridpulver (Korngröße nach FFS 1,5 µm) und 2,0 Gewichts-% Yttriumoxid mit einer Korngröße im Submicronbereich wurden in einer Mörsermühle aufgemahlen. Diese Mischung wurde durch ein Sieb mit einer Maschenweite von 60 µm durchgesiebt und in einer Matrize zu Plättchen einer Größe von 25 × 25 × 1 mm bzw. zu Stäbchen mit der Abmessung von 5 × 5 × 70 mm verpreßt. Die Plättchen und Stäbe wurden unter Verwendung einer Unterlage von Molybdänblech in eine graphitbeheizte Sinteranlage eingebracht.

Nach Evakuieren der Sinteranlage auf $10^{-5}$ mbar wurde ein Stickstoffdruck von 5 mbar eingeregelt. Innerhalb von 2 Stunden wurde auf eine Temperatur von 1 100 °C aufgeheizt. Während dieser Periode wurde ein Stickstoffdruck von 5 mbar aufrechterhalten. Bei 1 100 °C wurde ein Stickstoffdruck von 120 mbar aufgegeben, und die Ventile wurden geschlossen. Innerhalb einer Stunde wurde auf 1 800 °C aufgeheizt. Bei dieser Temperatur hat sich ein Stickstoffdruck von 180 mbar eingestellt. Nach einer zweistündigen Haltezeit bei diesen Bedingungen wurde die Anlage abgeschaltet und innerhalb von ca. 12 Stunden auf Raumtemperatur abgekühlt. Danach wurde die Anlage belüftet, und die gesinterten Plättchen und Stäbe wurden entnommen. Die Plättchen werden unmittelbar oder nach einseitigem Polieren zur Dickschichtpaste-Beschichtung verwendet. Die Stäbe werden gegebenenfalls ringsherum überschliffen oder unmittelbar auf einer Innenlochsäge in dünne quadratische Plättchen geschnitten, die ihrerseits für die Bedampfung verwendet werden.

Die Wärmeleitfähigkeit dieses Tragers beträgt 184 W/m K. Die Härte, gemessen in Knoop mit einer Belastung von 500 g, beträgt durchschnittlich 955.

Die gemessene Wärmeleitfähigkeit an dem erfindungsgemäßen Material liegt je nach Art und Menge des Zusatzes durchschnittlich zwischen 140 und 180 W/m K und somit bis zu sechsmal höher als bei reinem Aluminiumoxid. Diese Werte wurden an Materialproben mit einer relativen Dichte zwischen 90 und 98 % der theoretischen Dichte ermittelt. Bei zunehmender Verdichtung und bei Einsatz eines reineren Materials nimmt die Wärmeleitfähigkeit weiter zu. Der am erfindungsgemäßen Material höchste bisher gemessene Härtewert (Knoop 500 g Belastung) liegt bei 1110, wohingegen bei demselben undotierten Ausgangsmaterial maximal eine Härte von 240 erreichbar ist.

## Patentansprüche

1. Keramischer Träger auf Aluminiumnitrid-Basis mit hoher thermischer Leitfähigkeit für Halbleiterbauelemente oder elektronische Schaltungen, dadurch gekennzeichnet, daß er aus Aluminiumnitrid mit einem Zusatz aus 0,1 bis 3 Gewichts-% Bornitrid oder 0,1 bis 5 Gewichts-% Titan-, Zirkonium- und/oder Chromoxid oder 2 Gewichts-% Yttriumoxid besteht.

2. Keramischer Träger nach Anspruch 1, dadurch gekennzeichnet, daß der Bornitrid-Zusatz 0,5 bis 2 Gewichts-% beträgt.

## Claims

1. Aluminium nitride -based ceramic carrier with high thermal conductivity for semiconductor elements or electronic circuits, characterised in that it comprises aluminium nitride with an additional component of 0.1 to 3 weight % boron nitride or 0.1 to 5 weight % titanium, zirconium or chromium oxide or 2 weight % yttrium oxide.

2. Ceramic carrier according to claim 1, characterised in that the boron nitride content amounts to 0.5 to 2 weight %.

## Revendications

1. Support céramique à base de nitrure d'aluminium et ayant une haute conductivité thermique, pour composants à semiconducteurs ou circuits électroniques, caractérisé en ce qu'il est en nitrure d'aluminium avec une addition de 0,1 à 3 % en poids de nitrure de bore ou 0,1 à 5 % en poids d'oxyde de titane, zirconium et/ou chrome ou 2 % en poids d'oxyde d'yttrium.

2. Support céramique selon la revendication 1, caractérisé en ce que l'addition de nitrure de bore est de 0,5 à 2 % en poids.